(19) Europäisches Patentamt
European Patent Office
Office européen des brevets

(11) **EP 1 863 171 A1**

(12) **EUROPEAN PATENT APPLICATION**

(43) Date of publication:
**05.12.2007 Bulletin 2007/49**

(51) Int Cl.:
***H03F 3/45*** (2006.01)

(21) Application number: **06011220.8**

(22) Date of filing: **31.05.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **STMicroelectronics S.r.l.**
**20041 Agrate Brianza (Milano) (IT)**

(72) Inventor: **Dalena, Francesco Maria**
**70017 Putignano (Bari) (IT)**

(74) Representative: **Ferrari, Barbara**
**Botti & Ferrari S.r.l.,**
**Via Locatelli, 5**
**20124 Milano (IT)**

(54) **Operational amplifier of class AB**

(57)     The present invention relates to an operational amplifier (1) of class AB including a core (2) of the OTA type which comprises:
- first and second input transistors (M1, M2) being inserted between first and second internal nodes (A, B), respectively, and a first common node (X1) and having respective control terminals connected to first and second differential input terminals (IN-, IN+); first and second input stage load transistors (M3, M4) being diode connected and inserted between a first voltage reference (Vdd) and the first and second internal nodes (A, B), respectively;
- first and second output transistors (M6, M8) being inserted, in series to each other, between the first voltage reference (Vdd) and a second voltage reference (GND) and being interconnected at an output terminal (OUT) of the operational amplifier (1), the first output transistor (M6) having a control terminal connected to a control terminal of the second input stage load transistor (M4); and
- a tail current generator (G1) being inserted between the first common node (X1) and the second voltage reference (GND);

the operational amplifier (1) further comprising an adaptive bias block (3) inserted between the first and second voltage references (Vdd, GND) and connected to the first common node (X1) of the core (2).

Advantageously according to the invention, the operational amplifier (1) further comprises a positive feedback network (7) inserted between the first voltage reference (Vdd) and the first and second internal nodes (A, B).

FIG. 1

EP 1 863 171 A1

**Description**

Field of application

The present invention relates to an operational amplifier of class AB, in particular for low voltage application.
More specifically, the invention relates to an operational amplifier of class AB including a core of the OTA type which comprises:

- first and second input transistors being inserted between first and second internal nodes, respectively, and a first common node and having respective control terminals connected to first and second differential input terminals;

- first and second input stage load transistors being diode connected and inserted between a first voltage reference and said first and second internal nodes, respectively;

- first and second output transistors being inserted, in series to each other, between said first voltage reference and a second voltage reference and being interconnected at an output terminal of said operational amplifier, said first output transistor having a control terminal connected to a control terminal of said second input stage load transistor; and

- a tail current generator being inserted between said first common node and said second voltage reference;

the operational amplifier further comprising an adaptive bias block inserted between said first and second voltage references and connected to said first common node of said core.

Prior art

As it is well known, the increased complexity of mixed-signal Integrated Circuits or IC's makes it crucial to optimise the power consumption of the same.
Moreover, the current marked of IC's requires more and more a shift toward low voltage applications, making the power consumption optimisation even more critical.
In this aim, low power architectures have to be used as building blocks of a whole IC and innovative circuit topologies have to be explored.
It is also well known that the operational amplifier (briefly, op-amp) is probably the most widely used building block in analog IC's, as described for instance in the article to WANG et al. entitled: "Optimal design for oversampled converter", Proc. IEEE Custom Integrated Circuit Conf., 1996, pp. 337-340.
In particular, in a wide number of applications (for example, in switched capacitors circuits or in output stages circuits), the op-amps have to charge large capacitive loads. In these cases, the op-amps have to tracks large signal in a limited time slot.
He known op-amps can be substantially divided in two main groups or classy, namely the A and AB class of amplifiers.
Class A op-amps have poor behavior with large signals due to their constant tail current and thus they show a transient response being slew-rate limited, as described by KLINKE et al. in the article entitled: "A Very-High- Slew-Rate CMOS Operational Amplifier", IEEE Journal of Solid- State Circuits, vol. 24, no. 3, June 1989.
In case of large signals to be tracked, an alternative solution is thus the use of class AB op-amps, with push-pull output stage, as described in the article of HOGERVORST et al.: "A Compact Power-Efficient 3V CMOS Rail-to-Rail Input/Output Operational Amplifier for VLSI Cell Libraries", IEEE Journal of Solid-State Circuits, vol. 29, no. 12, December 1994.
The circuit topology described in this article, being a class AB op-amp, easily overcomes slew rate problems. However, it should be noted that such a circuit has a maximum output current which is not well controlled: this could be a problem in low-power applications, especially where a portable system with a battery aboard is concerned.
Yet another known solution is described by CALLEWAERT et al. in the article entitled: "Class AB CMOS amplifiers with high efficiency", IEEE Journal of Solid-State Circuits , vol. 25, no. 3, June 1990. In this case, the proposed op-amp topology provide a boosting of the tail current of input differential transistors comprised therein for large signal operation. In this way, the current of the whole op-amp is increased in this operation state. This boosting mechanism is usually referred to as adaptive bias.
An op-amp topology realised according to the adaptive bias principle and being able to drive large capacitive load is described in the article to DEGRAUWE et al. entitled: "Adaptive biasing CMOS amplifier", IEEE Journal of Solid-State Circuits, vol. SC-17, pp. 522-528, June 1982.

Also this known solution has however a main problem due to the fact that the DC-gain of the op-amp so obtained is limited, since it has just one pole at high impedance on its output node.

The technical problem underlying the present invention is that of providing an operational amplifier based on the adaptive bias principle and having structural and functional characteristics which allow to reduce its power consumption and, in a same time, enhance its DC-gain, in this way overcoming the limits which still affect the amplifiers realised according to the prior art.

Summary of the invention

The solution idea underlying the present invention is that of providing an operational amplifier having a fully symmetrical core, in particular realised by an OTA in order to reduce its power consumption connected to a adaptive bias block implementing the adaptive bias principle and comprising a positive feedback biasing block in order to enhance the DC-gain of the operational amplifier.

On the basis of such solution idea the technical problem is solved by an operational amplifier as previously indicated and defined by the characterising part of claim 1.

The characteristics and advantages of the operational amplifier according to the invention will be apparent from the following description of an embodiment thereof given by way of indicative and non limiting example with reference to the annexed drawings.

Brief description of the drawings

In such drawings:

Figure 1 schematically shows an operational amplifier according to the invention;

Figure 2 schematically shows a core of the operational amplifier of Figure 1;

Figure 3 schematically shows a further detail of the operational amplifier of Figure 1;

Figure 4 schematically shows a bode diagram of the operational amplifier of Figure 1; and

Figures 5A and 5B schematically show internal signals of an operational amplifier according to the invention in different configurations thereof.

Detailed description

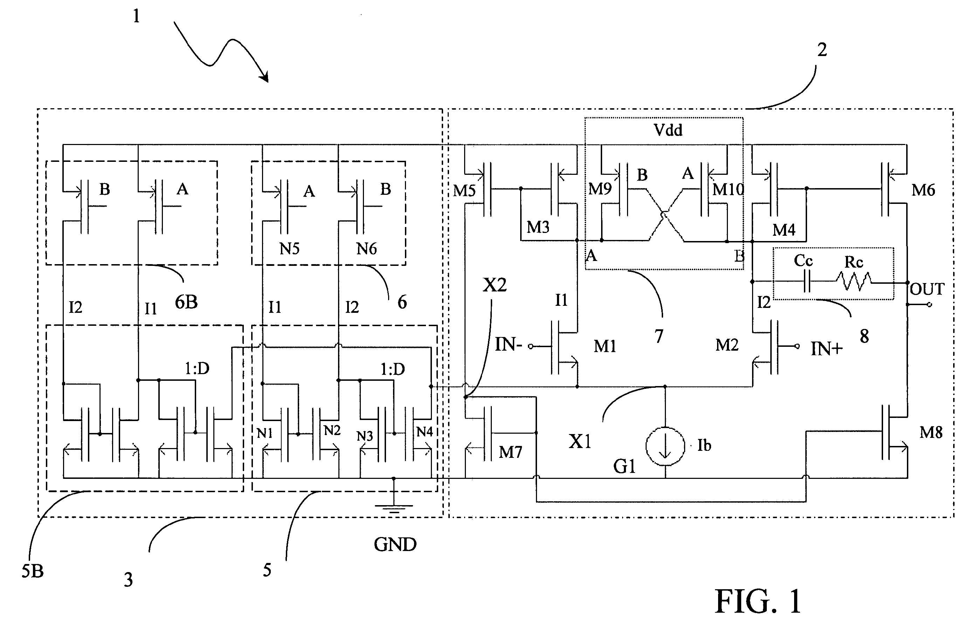

With reference to such figures, and in particular to Figure 1, an operational amplifier or op-amp realised according to the invention is schematically shown, globally indicated with 1.

The op-amp 1 essentially comprises a core 2 and an adaptive bias block 3, inserted between a first and a second voltage reference, in particular a supply voltage reference Vdd and ground GND, and interconnected in correspondence of a first common node X1.

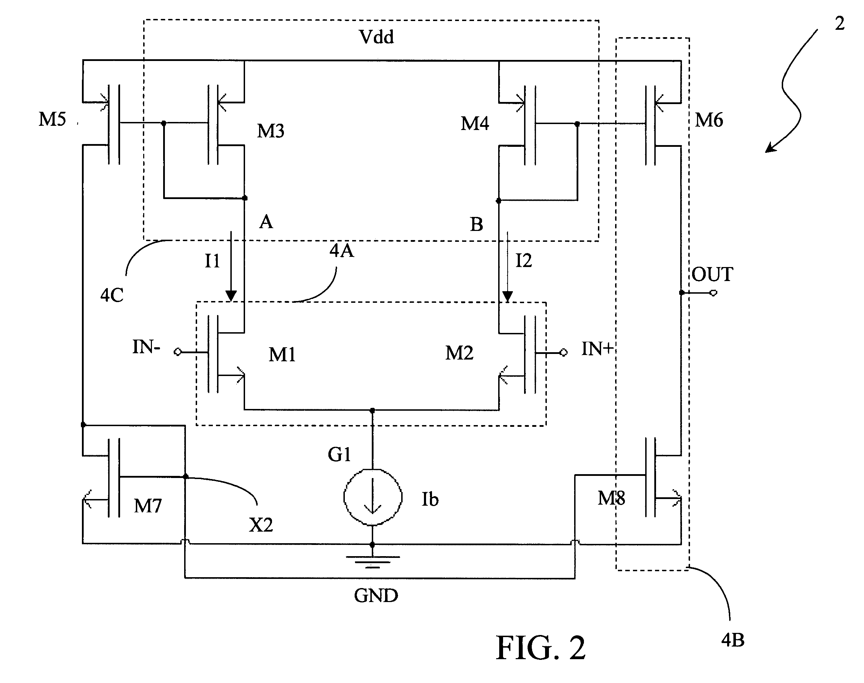

Advantageously according to the invention, the core 2 is realised by an OTA (Operational Transconductance Amplifier), as shown in Figure 2, also indicated with 2. More particularly, the core 2 is a CMOS OTA with a symmetrical input stage comprising a first and a second input transistors M 1 and M2.

These input transistors M1 and M2 are inserted between respective first and second internal nodes, A and B, and the first common node X1 and have control or gate terminals connected to a first IN- and a second input terminal IN+ of the op-amp 1.

The OTA 2 also comprises a first and a second input load stage transistors M3 and M4 diode connected and inserted between the supply voltage reference Vdd and respective conductive terminals, in particular drain terminals of the input transistors M1 and M2 in correspondence with the first and second internal nodes, A and B.

Moreover, the first input stage load transistor M3 has a control or gate terminal connected to a control or gate terminal of a mirror transistor M5, in turn connected between to the supply voltage reference Vdd and a second common node X2.

The first input stage load transistor M4 has a control or gate terminal connected to a control or gate terminal of a first output transistor M6, in turn connected between to the supply voltage reference Vdd and aa output terminal OUT of the op-amp 1.

A biasing transistor M7 is inserted between the second common node X2 and ground GND and has a control or gate terminal connected to the second common node X2 and to a control gate of a second output transistor M8 being in turn inserted between the output terminal OUT and ground GND.

In particular, the OTA 2 has an input stage 4A comprising the input transistors M 1 and M2 and an output stage 4B comprising the first and second transistors M6 and M8, as well as an input stage load 4C comprising the first and second input stage load transistors M3 and M4.

The first common node X 1 is also connected to ground GND through a generator of a bias current Ib, also indicated as tail current generator G1.

The great advantage of this known amplifier topology is the its very good symmetry.

Advantageously, by suitably sizing the transistors comprised in this OTA 2, the current flowing in the transistors M5 and M6 is made K1 times greater than the current flowing in the first and second input stage load transistors M3 and M4, in order to obtain a GBW (Gain BandWidth) K1 times the GBW of a standard OTA configuration. It is however verified that the total power consumption of such an OTA 2 is (K1+1) times larger as well, factor K1 being normally increased to increase the slew rate.

The first and second internal nodes, A and B, are at low impedance, so a dominant pole of the transconductance function of the op-amp 1 is due to an output impedance of the OTA 2.

Advantageously according to the invention, the op-amp 1 exploits the adaptive bias principle, as described above, by using an adaptive bias block 3 connected to first common node X1.

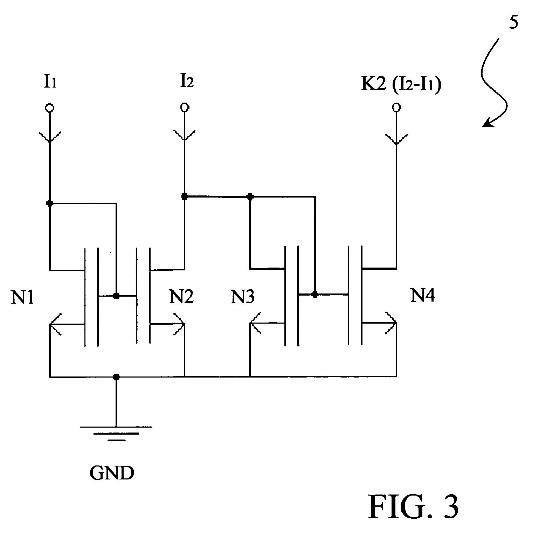

In particular, to boost a tail current of the input differential pairs of transistors M 1 and M1, a current subtractor is used, as shown in Figure 3, globally indicated with 5.

The current subtractor 5 comprises first and second additional transistors, N1 and N2, having respective control or gate terminals and first conductive terminals, in particular source terminals, in common, the common source terminals being connected to ground GND.

The first additional transistor N1 has a second conductive terminal, in particular a drain terminal connected to its gate terminal and receiving a current, which is a copy of the current flowing in the first input transistor M1 of the OTA 2 and is also labelled as I1. Moreover, the second additional transistor N2 also has a second conductive terminal, in particular a drain terminal receiving a current, which is a copy of the current flowing in the second input transistor M2 of the OTA 2 and is also labelled as 12.

The current subtractor 5 further comprises third and fourth additional transistors, N3 and N4, having respective control or gate terminals and first conductive terminals, in particular source terminals, in common, the common source terminals being connected to ground GND.

The third additional transistor N3 has a second conductive terminal, in particular a drain terminal, connected to its gate terminal and to the source terminal of the second additional transistor N2 and receiving a current 12, which is a copy of the current flowing in the second input transistor M2 of the OTA 2.

Finally, the fourth additional transistor N4 has a second conductive terminal wherein flows a boost current Is equal to:

$$Iss = K2(I2-I1) \hspace{3cm} (1)$$

The current subtractor 5 is connected in parallel to the tail current generator G 1 comprised in the OTA 2. In particular, as shown in Figure 1, the adaptive bias block 3 comprises a first 5 and a second current subtractor 5B inserted between the first common node X1 and ground GND. In this way, the current subtractor 5 correctly works in case of a signal applied to the first input terminal IN- of the OTA 2 which has a greater value than a signal applied to its second input terminal IN+, as well in the opposite signal condition. More particularly, the drain terminals of the fourth transistors N4 comprised in the current subtractors 5 and 5B are connected to the first common node X1.

The adaptive bias block 3 also comprises a first and a second mirror block, 6 and 6B, inserted between the supply voltage reference Vdd and the current subtractors 5 and 5B and comprises respective sixth and seventh additional transistors, N6 and N7, inserted between the supply voltage reference Vdd and the drain terminals of the first and second additional transistors, N 1 and N2, and having respective control or gate terminals connected to the first and second internal nodes, A and B, in order to provide the copy-currents I1 and I2 to the current subtractors 5 and 5B.

In this way, in quiescent condition, no boost current Iss is generated because there is no current flowing throughout the additional third transistors N3 and consequently throughout the fourth ones N4.

When the input voltages at the input terminals IN- and IN+ are unbalanced, the currents I1 and I2 flowing in the first and second input transistors, M1 and M2 (and thus the copy-currents provided to the current subtractors 5 and 5A) are different so that a boost current Iss flows in the fourth additional transistors N4 according to the above equation (1).

The drain terminal of the fourth additional transistor N4 is in parallel with the tail current generator G 1 so that the bias current Ib of the op-amp 1 is signal dependent, the adaptive bias block 3 realising an adaptive bias mechanism as explained above.

The parameter K2 is usually indicated as current feedback factor and it is related with the stability of the whole op-amp 1.

When the input transistors M 1 and M2 of the OTA 2 are operating in the weak inversion region, a maximum value of transconductance for a given current is reached, thus fulfilling low power requirements.

In particular, indicating with Vin the voltage across the gate terminals of the input transistors M1 and M2, which correspond to the input terminals IN- and IN+ of the op-amp 1, the following relation is verified:

$$I1 = I2 \cdot \exp(Vin/(nV_T)) \qquad (2)$$

being n the so called weak inversion slope factor and $V_T$ the threshold voltage of the input transistors M 1 and M2.

For a current feedback factor K2 between 0 and 1, the maximum value of a possible load current at the output terminal OUT of the op-amp 1 is limited to the value: Ib/(1-K2).

If the current feedback factor K2 is larger than unity, the maximum value of the load current becomes instead unlimited, so that the op-amp 1 will never slew.

In real conditions, such output current, of course, will not reach an infinite value because the input transistors M1 and M2 will switch in the weak inversion region.

Advantageously according to the invention, the OTA core 2 of the op-amp 1 further comprises a positive feedback network 7 inserted between the supply voltage reference Vdd and the first and second internal nodes, A and B.

In particular, the positive feedback network 7 comprises:

- a first feedback transistor M9 inserted between the supply voltage reference Vdd and the first internal node A and having a control or gate terminal connected to the second internal node B; and

- a second feedback transistor M10 inserted between the supply voltage reference Vdd and the second internal node B and having a control or gate terminal connected to the first internal node A.

In this way, advantageously according to the invention, in bias conditions, a good current mirror between the input transistors M 1 and M2 of the op-amp 1 and the adaptive bias block 3 is guaranteed, so that the power consumption of the op-amp 1 can be controlled. More particularly, the op-amp 1 according to the invention has a good control of the current which flows in the overall architecture, being substantially made by a plurality of current mirrors, thus improving the op-amp performances with respect to the known solutions for op-amp of the class AB comprising a push/pull architecture, wherein the current is not well controlled, especially in process corners.

It is immediate to verify that the impedance at the internal nodes A and B is equal to 1 /gm3,4 when no positive feedback network 7 is provided, being gm3,4 the trasconduttance value of the first input stage load transistors M3 and M4.

Advantageously according to the invention, the positive feedback network 7 adds a feedback transistor, M9 and M10 respectively, in parallel to each branch of the input stage load 4C, i.e. to the first input stage load transistors M3 and M4 respectively.

The gate terminals of the feedback transistors M9 and M10 are connected to a respective drain terminal of an input stage load transistor in an opposite branch, M4 and M3, respectively.

In this way, a parallel resistance equal to -1 / gm9,10 (being gm9,10 the transconductance value of the feedback transistors M9 and M10) is added at the first and second internal nodes, A and B, so that a infinitely impedance is theoretically reached, if output resistances of these transistors are neglected.

The op-amp 1 according to the invention thus has a higher DC-gain with respect to the known solutions, without increasing the power consumption. More particularly, the DC-gain of the op-amp 1 can be calculated as follows:

$$A_{dc,in} = \frac{gm1}{gm3 - gm5 + gds3 + gds5 + gds1} \qquad (3)$$

being

gm1, gm3 and gm5 the transconductance value of the transistors M1, M3 and M5; and

gds1, gds3 and gds5 the drain-source conductance of the transistors M 1, M3 and M5.

In summary, advantageously according to the invention, the input transistors M 1 and M2 and the feedback transistors M5 and M6 of the positive feedback network 7 form a positive feedback loop.

Furthermore, as it is well known, in order to guarantee the stability of a positive loop, its loop gain has to be inferior to the unity. For the op-amp 1 shown in Figure 1, the loop gain Gloop can be calculated as follows:

$$Gloop = \frac{gm5}{gm3 + gds3 + gds5 + gds1} \tag{4}$$

being

gm3, and gm5 the transconductance value of the transistors M3 and M5; and

gds1, gds3 and gds5 the drain-source conductance of the transistors M1, M3 and M5.

If the transconductance value gm3 of the first input stage load transistors M3 is equal to the transconductance value gm5 of the mirror transistors M5, the stability of the positive loop of the op-amp 1 is guaranteed by the parasitic resistances inherent to the op-amp 1.

In particular, a DC-gain equal to 90dB is comparable to a typical two stages op-amp.

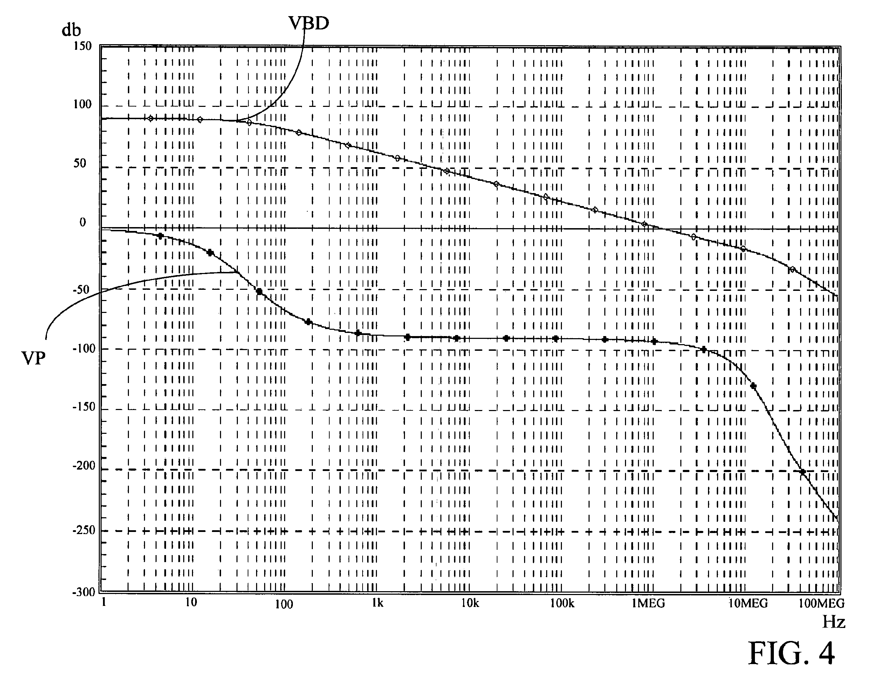

A Bode diagram of the op-amp 1 is shown in Figure 4. It can be verified that the DC-gain is high as a two poles known system and the phase margin is equal to 85°.

The presence of the two poles also highlight the need of a compensation mechanism for ensuring the stability of the op-amp 1.

For sake of stability, advantageously according to the invention, the op-amp 1 further comprises a RC network compensation circuit 8 providing a compensation via Miller effect.

More particularly, the RC network compensation circuit 8 comprises a capacitor Cc and a resistor Rc inserted, in series to each other, between the second internal node B and the output terminal OUT of the op-amp 1.

In this way, the RC network compensation circuit 8 introduce a zero according to the following relation:

$$z = \frac{1}{Cc\left(\dfrac{1}{gm} - Rc\right)} \tag{5}$$

In particular, to push the frequency of the introduced zero to infinity, the value of the resistor Rc is chosen equal to 1/gm, thus avoiding the introduction of a polo-zero doublet.

As it is well known, the transconductance value of a transistor can be calculated, in the strong and weak inversion condition, as follows:

$$gm, strong = \sqrt{2\mu Cox \frac{W}{L} Id} \tag{6}$$

$$gm, weak = \frac{Id}{nV_T} \tag{7}$$

The equations (6) and (7) presume a small signal at the input terminals IN- and IN+ of the op-amp 1. However, advantageously according to the invention, these equations are still effective in case of large signals by replacing the current value Id with half of the a load current given by:

$$Iss = Ib + K2|(I2-I1)| \tag{8}$$

and choosing a value of the current feedback factor K2 equal or smaller than unity, Ib being the current available in the quiescent condition at the sources of coupled transistor pairs.

The Applicant has estimated the stability of the op-amp 1 when a large signal is applied to its input terminals IN- and IN+ by using the technique described by PALUMBO et al. in the article: "Feedback Amplifier", Kluwer, Boston, pp.90, 2002.

In particular, as described in this article, a relative stability can be characterized by the phase margin (PM) in frequency domain and by the so called overshoot of the step response in time domain as a function of separation factor W, which in case of Miller compensation, are given as:

$$W = \frac{p_2}{\omega_{GBW}} = \frac{gmL/CL}{gm1/Cc} = \tan(PM) \tag{9}$$

and

$$overshoot = e^{-\pi\sqrt{\frac{W}{4-W}}} \tag{10}$$

wherein:

gmL and gm1 are small signal transconductances of the output and input stages, respectively; and

CL and Cc are load and Miller capacitance, respectively.

From the above equations (9) and (10) it is immediate to verify that if small signal transconductances are replaced by amplitude dependent transconductances, as discussed above, relative stability is not changed, since the transconductance ratios of equation (9) will remain constant.

In other words, for large signals the op-amp 1 according to the invention have approximately the same relative stability as its linear counterpart.

The above conclusion on stability is true if the input transistors M 1 and M2 of the op-amp 1 and the output transistors work in a same region, in particular in the saturation or weak inversion regions.

More particularly, if the input transistors work in the weak inversion, the small signal transconductance gm1 of the input transistors changes along with the drain current Id flowing in these transistors and small signal transconductance gmL of the output transistors changes along with the root of the drain current Id flowing therein.

Thus, in the weak inversion conditions, the separation factor W decreases and, therefore, the phase margin PM is reduced and the stability could be compromised.

In this case, for a good compensation over all input dynamic range, advantageously according to the invention, the current feedback factor K2 is chosen small, for instance between 0 and 1, so that the resistance value 1/gm1,2, that is signal dependent, do not change so much.

The above features of the op-amp 1 according to the invention have been verified by the Applicant through suitable simulations.

In particular, the op-amp 1 shown in Figure 3, has been designed in a 0,5 μm CMOS technology with a 2,4V supply voltage reference.

It has been thus verified that:

- the current consumption is the 10 μA for a total power consumption of 24 μW;

- the DC-gain of the op-amp 1 is 90dB with a GainBandwith of 1,2MHz;

- in a buffer connected condition, i.e. using the positive feedback network 7, the op-amp 1 is able to drive a capacitive output load of 10 pF in a time slot of 1 $\mu$s with a precision of 0,1 %.

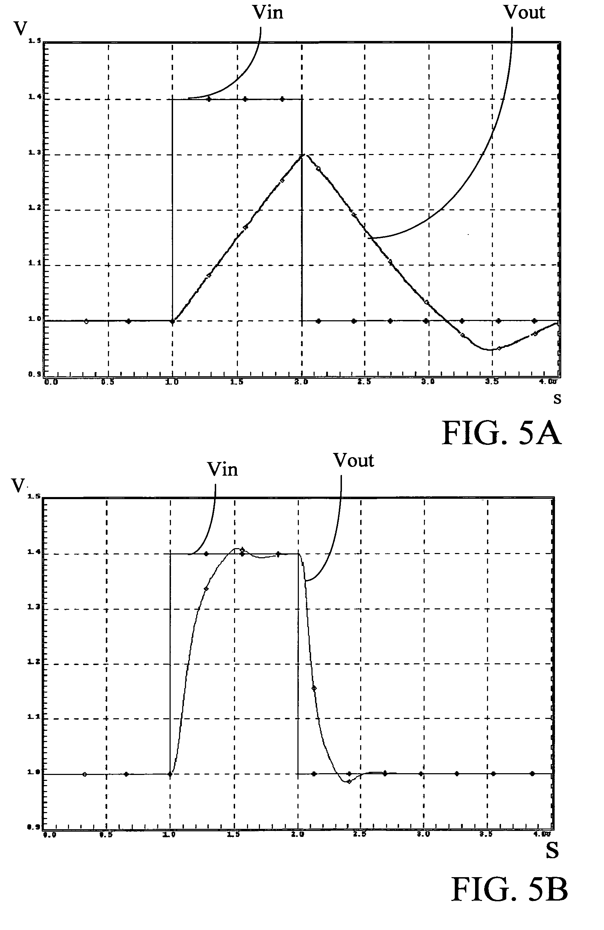

The results of the performed simulation are shown in Figures 5A and 5B.

More particularly, Figure 5A shows an output voltage Vout issued by a buffer op-amp 1 for an input voltage Vin being a step of 0,4V when adaptive bias mechanism is not used. It is immediately clear that in this condition the op-amp 1 suffers of slew rate problem and the output voltage Vout does not reach a desired value.

The small current of the op-amp 1 is in fact unable to drive in linear mode a load capacitor connected to its output terminal OUT and the slew rate is given by the current provided by the tail current generator G 1 divided by the compensation capacitor Cc of the RC network compensation circuit 8.

Figure 5B shows a same transient simulation for an op-amp 1 using the adaptive bias mechanism (i.e. comprising the adaptive bias block 3). In this case, the op-amp 1 settles in 1 $\mu$s with a 0,1 % of precision.

It is thus verified that the op-amp 1 according to the invention comprising a adaptive bias block 3 and a positive feedback network 7 is able to charge a big capacitive load with very low current and a sufficient precision (given by its high DC-gain) is achieved.

The following Table 1 resumes the specifications of the op-amp 1 which has been simulated by the Applicant and its measured features.

Table 1

| Technology | CMOS 0,5$\mu$m |
| --- | --- |
| Power supply | 2,4V |
| Cload | 10pF |
| Settling time @ 0,1% | 1 $\mu$s |
| DC-gain | 90dB |
| GBW | 1,2MHz |
| Phase Margin | 85° |
| Power consumption | 24$\mu$W |

In conclusion, the op-amp 1 according to the present invention is a class AB amplifier suitable to drive large capacitive load in low-voltage low-power applications having a low-power consumption and an adaptive biasing as well as an enhanced DC-gain.

In particular, the impedance seen at the drain terminals of the differential input pair of transistors M1 and M2 is enhanced by the positive feedback network 7 comprising the transistors M5 and M6 so that to enhance the gain of the whole op-amp 1.

Moreover, the op-amp 1 comprises a adaptive bias block 3 to regulate its own bias currents and to have a better efficiency in the use of the supply current to charge and discharge an output load. In particular, if no signal is applied to the input terminals IN- and IN+, the op-amp 1 operates at very low current level, i.e. in a sleeping mode. When a differential signal Vin is applied to the input terminals IN- and IN+ of the op-amp 1, the current in the input transistors M1 and M2 is boosted to enhance the slew-rate and achieve a good settling in a required time slot. So, the bias currents are adjusted by sensing an input signal amplitude.

Furthermore, the proposed op-amp 1 has a slew rate with a great boost so the it is able to manage large input signal in the same manner of small input signal.

Finally, the op-amp 1 solves the problem of the poor DC-gain of the known solution by using a positive feedback structure that enhances the whole op-amp gain up to 90dB (i.e. like a two poles amplifier).

In this way, the proposed op-amp topology could be used in very low voltage applications with a typical supply voltage of 1,2V or even below.

Useful applications of the op-amp 1 according to the invention are for example in the field of biomedical systems and micro-sensor systems where power dissipation is an important specification for life time battery.

**Claims**

1. An operational amplifier (1) of class AB including a core (2) of the OTA type which comprises:

- first and second input transistors (M1, M2) being inserted between first and second internal nodes (A, B), respectively, and a first common node (X1) and having respective control terminals connected to first and second differential input terminals (IN-, IN+);

- first and second input stage load transistors (M3, M4) being diode connected and inserted between a first voltage reference (Vdd) and said first and second internal nodes (A, B), respectively;

- first and second output transistors (M6, M8) being inserted, in series to each other, between said first voltage reference (Vdd) and a second voltage reference (GND) and being interconnected at an output terminal (OUT) of said operational amplifier (1), said first output transistor (M6) having a control terminal connected to a control terminal of said second input stage load transistor (M4); and

- a tail current generator (G1) being inserted between said first common node (X1) and said second voltage reference (GND);

the operational amplifier (1) further comprising an adaptive bias block (3) inserted between said first and second voltage references (Vdd, GND) and connected to said first common node (X1) of said core (2) and being **characterised in that** it further comprises a positive feedback network (7) inserted between said first voltage reference (Vdd) and said first and second internal nodes (A, B).

2. The operational amplifier (1) according to claim 1, **characterised in that** said positive feedback network (7) comprises:

   - a first feedback transistor (M9) inserted between said first voltage reference (Vdd) and said first internal node (A) and having a control terminal connected to said second internal node (B); and
   - a second feedback transistor (M10) inserted between said first voltage reference (Vdd) and said second internal node (B) and having a control terminal connected to said first internal node (A).

3. The operational amplifier (1) according to claim 2, **characterised in that** it further comprises a compensation circuit (8) inserted between said second internal node (B) and said output terminal (OUT).

4. The operational amplifier (1) according to claim 3, **characterised in that** said compensation circuit (8) is a RC network comprising a capacitor (Cc) and a resistor (Rc) inserted, in series to each other, between said second internal node (B) and said output terminal (OUT).

5. The operational amplifier (1) according to claim 1, **characterised in that** said core (2) further comprises a mirror transistor (M5) being inserted between said first voltage reference (Vdd) and a first common node (X2) and having a control terminal connected to said control terminal of said first input stage load transistor (M3).

6. The operational amplifier (1) according to claim 5, **characterised in that** said core (2) further comprises a biasing transistor (M7) being diode connected and inserted between said second common node (X2) and said second voltage reference (GND) and having a control terminal connected to a control terminal of said second output transistor (M8).

7. The operational amplifier (1) according to claim 1, **characterised in that** said adaptive bias block (3) comprises at least a current subtractor (5) and a mirror block (6) inserted, in series to each other, between said first and second voltage references (Vdd, GND).

8. The operational amplifier (1) according to claim 7, **characterised in that** said current subtractor (5) comprises:

   - first and second additional transistors (N1, N2), having respective control terminals connected to each other and to said mirror block (6) and first conductive terminals connected to each other and to said second voltage reference (GND), said first additional transistor (N1) having a second conductive terminal connected to its control terminal and to said mirror block (6) and said second additional transistor (N2) having a second conductive terminal connected to said mirror block (6);
   - third and fourth additional transistors (N3, N4), having respective control terminals connected to each other, to said second control terminal of said second additional transistor (N2) and to said mirror block (6) and first conductive terminals connected to each other and to said second voltage reference (GND), said third additional transistor (N3) having a second conductive terminal connected to its control terminal and to said mirror block (6) and said second additional transistor (N2) having a second conductive terminal connected to said first common node (X1) of said core (2).

9. The operational amplifier (1) according to claim 8, **characterised in that** said mirror block (6) comprises respective sixth and seventh additional transistors (N6, N7), inserted between said first voltage reference (Vdd) and said second conductive terminals of said first and second additional transistors (N1, N2), respectively, and having respective control terminals connected to said first and second internal nodes (A, B) in order to provide currents (I1, I2) equal to the current flowing throughout said first and second input transistors (M1, M2) of said core (2).

10. The operational amplifier (1) according to claim 7, **characterised in that** it comprises further current subtractor (5B) and mirror block (6B) inserted, in series to each other, between said first and second voltage references (Vdd, GND), the second conductive terminal of said fourth additional transistor of said further current subtractor (5B) being connected to said first common node (X1) and the control terminals of said sixth and seventh additional transistors of said further mirror block (6B) being connected to said first and second internal nodes (A, B).

FIG. 1

FIG. 2

$I_1$      $I_2$      K2 $(I_2-I_1)$

5

N1      N2    N3      N4

GND

FIG. 3

FIG. 4

EP 1 863 171 A1

Vin    Vout

FIG. 5A

Vin    Vout

FIG. 5B

**European Patent**

**Office**

**EUROPEAN SEARCH REPORT**

Application Number

EP 06 01 1220

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 776 087 A1 (ITT IND GMBH DEUTSCHE [DE] MICRONAS GMBH [DE]) 28 May 1997 (1997-05-28) * the whole document * | 1-10 | INV. H03F3/45 |
| A | NOCETI FILHO S ET AL: "NEW CMOS OTA FOR FULLY INTEGRATED CONTINUOUS-TIME CIRCUIT APPLICATIONS" ELECTRONICS LETTERS, IEE STEVENAGE, GB, vol. 25, no. 24, 23 November 1989 (1989-11-23), pages 1674-1675, XP000075000 ISSN: 0013-5194 *Section: Convertor realisation* *Figure 2* | 1-10 | |
| A | US 6 600 483 B1 (AKITA SHINICHI [JP] ET AL) 29 July 2003 (2003-07-29) * column 10, line 55 - column 12, line 38; figure 2 * | 1-10 | |
| | | | **TECHNICAL FIELDS SEARCHED (IPC)** |
| | | | H03F |

The present search report has been drawn up for all claims

| Place of search | Date of completion of the search | Examiner |
|---|---|---|
| The Hague | 20 October 2006 | Aouichi, Mohamed |

EPO FORM 1503 03.82 (P04C01)

**ANNEX TO THE EUROPEAN SEARCH REPORT
ON EUROPEAN PATENT APPLICATION NO.**                    EP 06 01 1220

This annex lists the patent family members relating to the patent documents cited in the above-mentioned European search report.
The members are as contained in the European Patent Office EDP file on
The European Patent Office is in no way liable for these particulars which are merely given for the purpose of information.

20-10-2006

| Patent document cited in search report | | Publication date | Patent family member(s) | | Publication date |
|---|---|---|---|---|---|
| EP 0776087 | A1 | 28-05-1997 | AT DE | 201796 T 19543866 C1 | 15-06-2001 14-08-1997 |
| US 6600483 | B1 | 29-07-2003 | JP | 2001244761 A | 07-09-2001 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **WANG et al.** Optimal design for oversampled converter. *Proc. IEEE Custom Integrated Circuit Conf.,* 1996, 337-340
- **KLINKE et al.** A Very-High- Slew-Rate CMOS Operational Amplifier. *IEEE Journal of Solid- State Circuits,* June 1989, vol. 24 (3
- **HOGERVORST et al.** A Compact Power-Efficient 3V CMOS Rail-to-Rail Input/Output Operational Amplifier for VLSI Cell Libraries. *IEEE Journal of Solid-State Circuits,* December 1994, vol. 29 (12
- **CALLEWAERT et al.** Class AB CMOS amplifiers with high efficiency. *IEEE Journal of Solid-State Circuits,* June 1990, vol. 25 (3
- **DEGRAUWE et al.** Adaptive biasing CMOS amplifier. *IEEE Journal of Solid-State Circuits,* June 1982, vol. SC-17, 522-528
- **PALUMBO et al.** Feedback Amplifier. Kluwer, 2002, 90